Europäisches Patentamt

(19) European Patent Office

Office européen des brevets

(11) Publication number : **0 431 685 A1**

# (12) EUROPEAN PATENT APPLICATION

(21) Application number : 90203158.2

(22) Date of filing : 30.11.90

(51) Int. Cl.⁵ : **H01L 21/20**

(30) Priority : 05.12.89 US 446516

(43) Date of publication of application :
**12.06.91 Bulletin 91/24**

(84) Designated Contracting States :
**DE FR GB IT NL**

(71) Applicant : **N.V. Philips' Gloeilampenfabrieken**
**Groenewoudseweg 1**
**NL-5621 BA Eindhoven (NL)**

(72) Inventor : **Martinez, Andre**
**c/o INT. OCTROOIBUREAU B.V. Prof.**
**Holstlaan 6**
**NL-5656 AA Eindhoven (NL)**

(74) Representative : **Rensen, Jan Geert et al**
**Internationaal Octrooibureau B.V. Prof.**
**Holstlaan 6**
**NL-5656 AA Eindhoven (NL)**

(54) Method of forming thin defect-free strips of monocrystalline silicon on insulators.

(57) A method of forming thin defect-free monocrystalline layers of silicon on an insulator, said method comprising :

a) depositing on a monocrystalline silicon substrate (1) a thin layer of a dielectric material (3) ;

b) forming essentially parallel rectangular strips (5) of said dielectric material on said substrate ;

c) depositing a thin film of polycrystalline or amorphous silicon (9) on said strips of the dielectric material and the rectangular parallel-positioned exposed areas (7) of the substrate and

d) heating said strips of dielectric material while heating said film of polycrystalline or amorphous silicon by means of a zone heating source (15) in such a way that elongated molten zones (21) are formed while scanning the resultant layered structure relative to the zone- heating source, in a direction parallel to the axis of said strips, the heat of said zone source being sufficient to liquify a small portion of the dielectric layer below said molten zones, and while heating the substrate to the softening point temperature of the dielectric layer by a different heat source.

FIG. 3

# METHOD OF FORMING THIN DEFECT-FREE STRIPS OF MONOCRYSTALLINE SILICON ON INSULATORS

The invention in this application relates to a method of forming thin, defect-free strips of monocrystalline silicon on insulators, the so-called SOI structure. The production of thin monocrystalline silicon strips on insulators is well known in the semiconductor art.

For example it is known to form strips of monocrystalline silicon on an insulating substrate such as oxidized silicon or quartz by depositing a thin layer of polycrystalline or amorphous silicon on such a substrate and forming a small molten zone in the surface of the amorphous or polycrystalline silicon layer and scanning the molten zone across the silicon layer while the underlying insulating substrate is being heated. Crystallization of the molten silicon causes a monocrystalline layer of silicon to be formed.

Such a procedure is well documented in the art, for example in European Patent Application 0129261, Cline, U.S. Patent 4,590,130, J. Sakuari, J. Electronchem Soc. Solid-State Science and Technology, pp 1485-1488 (July 1986), C.L. Bleil et al, Mat. Es. Soc.? Symp. Proc., Vol. 35, pp 389, 692 and Japanese Kokai 6119116.

The methods described in this prior art literature all produce monocrystalline silicon layers having significant numbers of defects. These defects have been found to be due primarly to the presence of subgrain or low angle grain boundaries and apparently are caused by stress on the growing silicon crystal. Among the causes of such stress are considered to be chemical impurities in the silicon layer, surface roughnesses of the silicon layer and volume expansion due to freezing. Additionally differences between the thermal expansion coefficients of the silicon layer and the underlying substrate are also considered causes of such stress.

In U.S. Patent 4,743,567 a method is described for the formation of SOI structures in which the underlying substrate is an insulating substrate having a softening point at least 10°C below the melting point of the silicon layer and a slope of its viscosity versus temperature curve of less than zero and greater than negative infinity. According to this patent low melting temperature glasses such as phosphosilicate glass, borophosphosilicate glass, and aluminosilicate are examples of materials that may be employed as the substrate. Further according to the method of this patent, the layer of the silicon is heated by a zone heating source to form a convex solid-liquid interface in the layer of the silicon while heating the substrate at its annealing point and moving the layer structure relative to the zone heating source in such a manner that the solid-liquid interface moves along the layer of the silicon. During zone-melting the dielectric layer under the solid-liquid interface is liquified.

The method of this patent may be used to produce defect-free monocrystalline silicon layers of about three hundred microns in width and several millimeters in length.

However this method is unsuitable for large scale production as it requires the carefully focusing of two lamps and is therefore complex and costly.

Copending U.S. Application Serial No. 201,901, filed June 17, 1988 in which the present applicant is a co-applicant also shows a method of producing thin defect-free strips of monocrystalline silicon on an insulator. In the method described in this application a thin layer of polycrystalline or amorphous silicon is deposited on an insulating substrate having a softening point at least 10 C below the melting point of silicon and having a slope of its viscosity versus temperature curve of less than zero and greater than negative infinity. Narrow strips of the silicon layer are removed from the substrate in such a way that parallel-positioned rectangular strips of the silicon remain on the substrate. The silicon strips are heated by a zone heating source in such a manner that a solid-liquid interface is formed along the plane of the silicon strips and the interface forms an angle of at least 8° with the axes of these strips while heating the substrate at its annealing point and moving the resultant layered structure, in a direction parallel to the major axes of the strips, relative to the zone heating source which controlling the movement speed of the layered structure so as to cause the surface of the substrate opposing the solid-liquid interface to be liquified.

By the method of this patent monocrystalline silicon layers having defect-free areas of as wide as 300 μm may be produced.

However, for many purposes it is desirable that defect-free monocrystalline silicon layers of larger area size on insulators be produced.

An object of the instant invention is to provide a method of producing thin defect-free layers of monocrystalline silicon on an insulating substrate in which the sizes of the defect-free areas in the monosilicon layers are greatly increased.

According to the novel method of the instant invention defect-free areas of monocrystalline silicon layers of greatly increased size on insulating substrates may be produced by the following combination of steps :

A thin layer of a dielectric material is deposited on a monocrystalline silicon substrate. The dielectric material employed has a melting point that is at least 10°C below the melting point of silicon and has a slope of its viscosity versus temperature curve that is less than zero and greater than negative infinity.

Parallel-positioned rectangular strips of the dielectric material are formed on the substrate by removing essentially rectangular parallel-positioned strips of the dielectric material from the substrate.

A thin film of polycrystalline or amorphous silicon is then deposited on the resultant structure in such a manner that the strips of the dielectric material and the exposed rectangular parallel-positioned strips of the monicrystalline silicon substrate surface (or seed areas) are coated by the silicon film.

The strips of the dielectric material and the film of the polycrystalline or amorphous silicon are heated by a zone heating source the heat of which is focussed on the film in such a way that elongated molten zones having essentially straight solid-liquid interfaces are formed in the silicon film. The solid-liquid interfaces formed in the silicon film are oriented at about an angle of at least 10° relative to the major axes of the exposed areas of the mono-crystalline silicon substrate, while at the same time the resultant layered structure is scanned relative to the zone-heating source in a direction parallel to the major axes of the exposed areas of the substrate. The power of the zone heating source employed is such that a small portion of the dielectric layer below the molten zone is liquified.

While the layered structure is heated by the zone heating source in this manner the substrate is heated to a temperature below its melting point by a separate heating source.

By the method of the invention layers defect-free monocrystalline silicon on insulator of area sizes of as large as 1 mm by 80 mm have been produced.

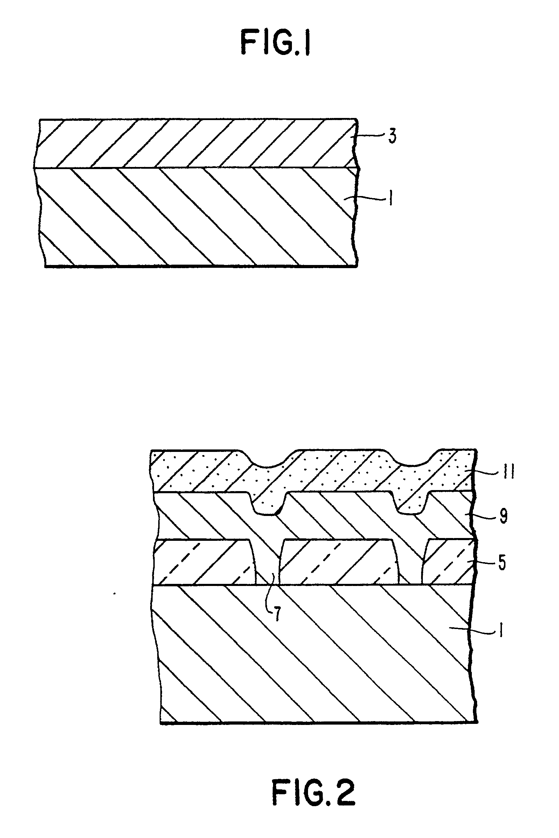

In the drawing, Fig. 1 is a cross-sectional view of a layered structure employed in one stage of the method of the invention ;

Fig. 2 is a cross-sectional view of a layered structure provided with seed vias formed from the structure of Fig. 1 after further processing according to the method of the invention ;

Fig. 3 is a diagrammatic view of a zone heating source for carrying out the method of the invention ;

Fig. 4 is a planar view of the formation of the molten zones during the scanning of the layered structure employed in the method of the invention.

For a more complete understanding the invention will now be discussed in greater detail with reference to the figures of the drawing.

Although many materials meet the requirement of the invention and may be employed as the dielectric material in the method of the invention it is preferred that these materials, in addition, have linear expansion coefficients compatible with silicon.

It has been found that soft glasses such as phosphosilicate glass, NA-40 (an almino-silicate glass produced by the Hoya Company) and 7059 glass produced by Corning Company are particularly useful.

The thickness of the dielectric layer may be about 500 Å and thicker.

The dielectric layer may be applied to the monocrystalline silicon substrate by any appropriate means such as chemical vapor deposition or sputter deposition.

The rectangular strips of the dielectric material may be formed in the dielectric layer by any convenient means. For example, photoetching is an example of a means for forming the strips of dielectric material that has been found to be highly useful.

The dielectric strip may be as long as will fit on the substrate. Preferably the dielectric strips are about 80 mm-100 mm long and about 100 $\mu$m-1000 $\mu$m wide. These strips are separated so as to leave exposed rectangular, essentially parallel strips of the monocrystalline silicon substrate preferably 10 $\mu$m-200 $\mu$m wide and 80 mm-100 mm long.

The polycrystalline or amorphous silicon layer is deposited so as to have a thickness of up to about 10 $\mu$m and preferably from 2000 Å-1.0 $\mu$m.

To prevent contamination of the polycrystalline or amorphous silicon layer by air-borne contaminants it is preferred that a thin layer of silicon dioxide of about 1 $\mu$m to 3 $\mu$m be deposited on this layer preferably by low temperature chemical vapor deposition.

Heating of the monocrystalline substrate may be provided by any convenient means such as a resistance heater. The substrate is heated to a temperature of about the softening point of the dielectric layer.

While the substrate is being heated a zone heating source such as a heat beam from a $CO_2$ laser is focused on the strips of the polycrystalline or amorphous silicon in such a manner as to cause an elongated molten silicon zone to form with an approximately straight interface between the molten silicon and the crystal growing from the molten zone. These elongated molten zones may be formed by focusing the laser beam with a cylindrical lens.

Sufficient power is used in the beam to melt a portion of the substrate covered by the molten silicon.

Preferably, the zone heating source is focused on the strips so that the molten silicon-growing crystal interface is oriented at an angle of about 10-80° and most preferably about 45° with the axis of the strips.

The molten silicon zone is scanned by the zone heating source in a direction parallel to the axis of the strips at a rate of up to 4 mm/sec.

The invention will now be described in greater detail with reference to the Figures of the drawing and the following example.

## Example

The preparation of the assembly to be subjected to zone heating will now be described with reference to Figures 1 and 2 of the drawing.

A monocrystalline silicon substrate 1, a thin layer 3 of a thickness of 1µm of a dielectric material such as phosphorsilicate glass is deposited. Employing methods well known in the field of microelectronics, the layer of phosphosilicate glass is etched through in a pattern so as to form essentially rectangular parallel strips 5, each of said strips being separated from each other by essentially parallel rectangular 10 µm wide strips 7 of the exposed surface of the monocrystalline substrate. A thin film 9, of approximately 1.0 microns thick of polycrystalline silicon is then deposited on the strips 5 of the phosphosilicate glass and the exposed strips 7 of the surface of the mono-crystalline silicon substrate.

In order to prevent airborne contamination of the film 9 of polycrystalline silicon a thin layer 11 of approximately 1.5 microns of silicon dioxide is then deposited on the layer 9 of the polycrystalline silicon. The resultant assembly is then placed in a heater and brought to a temperature of about 900°C. (not shown).

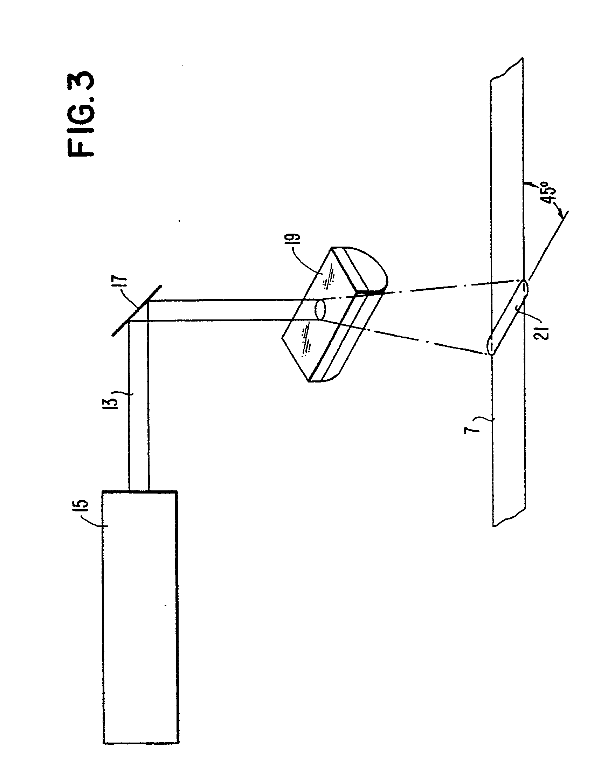

While the assmebly is being heated in this manner the assembly is scanned by a zone heating system of the type shown schematically in Fig. 3.

As shown in Fig. 3, a heat beam 13 having a diameter of 6.3 mm on a 50 watt $CO_2$ laser 15 is directed by plane mirror 17 into a cylindrical lens 19 the focal length of which is 121 µm mm, and arranged so that the major axis of the resultant spot 21 focused on the polysilicon film is elliptical with the major axis of the spot being angled at 45° relative to the major axis of the exposed strips 7 of the silicon substrate.

The spot 21 formed on the polycrystalline silicon strips forms an elongated molten zone having an essentially straight interface between the resultant silicon liquid and the growing monocrystalline silicon layer. The molten silicon liquid growing monocrystalline silicon interface is oriented at 45° relative to the exposed silicon substrate strips 7.

By the methods of the invention large defect-free monocrystalline silicon crystals of 1 mm x 80 mm and larger have been formed in a consistent reliable manner.

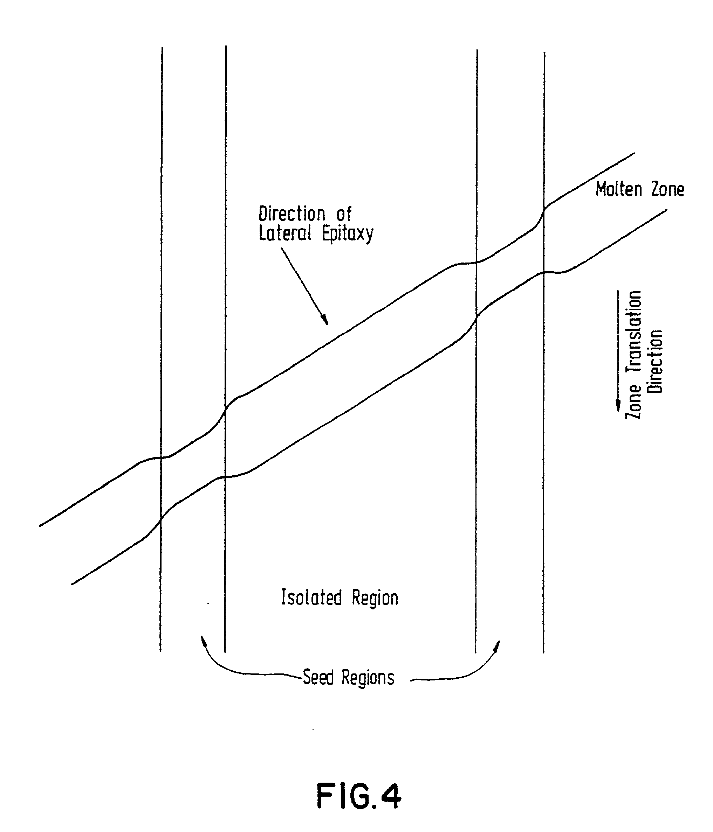

While it is not certain, it is believed the growth of the monocrystalline silicon layer proceeds according to the manner as shown in Fig. 4. It is believed that the growth of the monocrystalline silicon layer starts from the exposed strips of the monocrystalline silicon substrate (seed regions), proceeds by liquid phase epitaxy up from the substrate to the top of the seed regions then proceeds laterally across the strip of the phosphosilicate glass.

## Claims

1. A method of forming thin defect-free mono-crystalline layers of silicon on an insulator, said method comprising :
   a) depositing on a monocrystalline silicon substrate a thin layer of a dielectric material having a melting point at least 10°C below the melting point of silicon and a slope of its viscosity versus temperature curve of less than zero and greater than negative infinity ;
   b) removing essentially rectangular, parallel-positioned, narrow strips of said layer of dielectric material from the substrate to thereby form essentially parallel rectangular strips of said dielectric material on said substrate ;
   c) depositing a thin film of polycrystalline or amorphous silicon on said strips of the dielectric material and the rectangular parallel-positioned exposed areas of the substrate and
   d) heating said strips of dielectric material whileheating said film of polycrystalline or amorphous silicon by means of a zone heating source the heat of which is focussed on the film in such a way that elongated molten zones are formed in the film with essentially straight solid-liquid interfaces between the molten zones and the monocrystalline silicon zones growing from the molten zones and the solid-liquid interfaces formed in the film are oriented at about 10-80° relative to said exposed areas of said substrate while scanning the resultant layered structure relative to the zone-heating source, in a direction parallel to the axis of said strips, the heat of said zone zource being sufficient to liquify a small portion of the dielectric layer below said molten zones, and while heating the substrate to the softening point temperature of the dielectric layer by a different heat source.

2. The method of Claim 2 wherein the dielectric material is a low-melting point glass.

3. The method of Claim 2 wherein the dielectric material is selected from the group consisting of phosphosilicate glass, borophosphosilicate glass, and aluminosilicate.

4. The method of Claim 3 wherein a thin layer of silicon dioxide is deposited on said film of poly-crystalline or amorphous silicon.

5. The method of Claim 4 wherein the thin film of polycrystalline or amorphous silicon is about 1 micron thick.

6. The method of Claim 5 wherein the thin layer of silicon dioxide is about 1.5 microns thick.

7. The method of Claim 1 wherein the solid-liquid interfaces formed in the film of polycrystalline or amorphous silicon are oriented at about 45 degrees relative to the exposed areas of said substrate.

8. The method of Claim 1 wherein the layered structure is scanned relative to the zone-heating source at a rate of up to about 4 mm/sec.

# FIG.1

# FIG.2

FIG.3

EP 0 431 685 A1

FIG.4

**European Patent Office**

# EUROPEAN SEARCH REPORT

Application Number

EP 90 20 3158

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,X | EP-A-0 346 987 (N.V. PHILIPS' GLOEILAMPENFABRIEKEN) * Claims * | 1-8 | H 01 L 21/20 |
| A,D | US-A-4 743 567 (NORTH-AMERICAN PHILIPS) * Claims * | 1-8 | |
| A | 1989 IEEE MTT-S INT. MICROWAVE SYMP. DIGEST, Long Beach, CA, 13th - 15th June 1989, vol. 1, pages 969-972, IEEE, New York, US; T.J. LETAVIC et al.: "Recrystallized silicon-on-alumina as a monolithic circuit technology" * Figure 2; page 970, right-hand column, paragraphs 2-3 * | 1-8 | |
| A | JOURNAL OF APPLIED PHYSICS, vol. 61, no. 3, 1st February 1987, pages 1006-1014; S. HORITA et al.: "Characterization of silicon-on-insulator films recrystallized by an obliquely scanned pseudoline electron beam" * Abstract * | 1-8 | TECHNICAL FIELDS SEARCHED (Int. Cl.5) H 01 L |

The present search report has been drawn up for all claims

| Place of search | Date of completion of the search | Examiner |
|---|---|---|
| THE HAGUE | 04-03-1991 | GORI P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

&  : member of the same patent family, corresponding document

EPO FORM 1503 03.82 (P0401)